# EUROPÄISCHE PATENTSCHRIFT

(11) **EP 1 026 825 B1**
(45) Veröffentlichungstag und Bekanntmachung des Hinweises auf die Patenterteilung: **27.11.2002**
(21) Anmeldenummer: 00102462.9
(22) Anmeldetag: 04.02.2000
(51) Int. Cl.: H03J 5/24

(54) **Bandumschalteinrichtung**
Bandswitching device
Dispositif pour la commutation de bande

(30) Priorität: 04.02.1999 DE 19904588
(43) Veröffentlichungstag der Anmeldung: 09.08.2000
(73) Patentinhaber: Microtune GmbH & Co KG, 85055 Ingolstadt (DE)
(72) Erfinder: Reiss, Manfred, 85049 Ingolstadt (DE)
(74) Vertreter: Bohnenberger, Johannes, Dr.

(56) Entgegenhaltungen:
- GB-A- 2 196 197
- US-A- 5 483 209
- US-A- 5 752 179
- "SEMICONDUCTORS FOR TELEVISION AND VIDEO SYSTEMS - Product Specification - Handbook IC02" 1998 , PHILIPS , EINDHOVEN, NL XP002138297 * Seite 378 - Seite 382 *

## Beschreibung

Die Erfindung betrifft eine Bandumschalteinrichtung für einen n-Band-Tuner, insbesondere Drei-Band-Tuner, gemäß dem Oberbegriff des Patentanspruches 1.

Weiterhin betrifft die Erfindung einen entsprechenden n-Band-Tuner. Außerdem betrifft die Erfindung die Verwendung einer integrierten PLL-Schaltung in einer Bandumschalteinrichtung für einen n-Band-Tuner.

Drei-Band-Tuner werden beispielsweise in Fernsehempfängern verwendet. Das Frequenzspektrum der Fernsehsignale wird üblicherweise in das sogenannte UHF-Band, VHF-Band und Hyperband eingeteilt. Die HF-Signale werden in einem Tuner auf eine Zwischenfrequenz heruntergemischt. In einem Drei-Band-Tuner wird dazu üblicherweise eine Misch/Oszillatorstufe verwendet, die für jedes Frequenzband eine eigene Baugruppe aufweist. Als Bandumschalteinrichtung wird üblicherweise ein Phasenregelkreis verwendet. Der Phasenregelkreis ist extern ansteuerbar, damit ein einem gewünschten Kanal entsprechendes Signal zugeführt werden kann. Der Phasenregelkreis steuert die Misch/Oszillatorstufe derart an, daß sowohl die dem Kanal zugeordnete Frequenz als auch das entsprechende Frequenzband eingestellt werden.

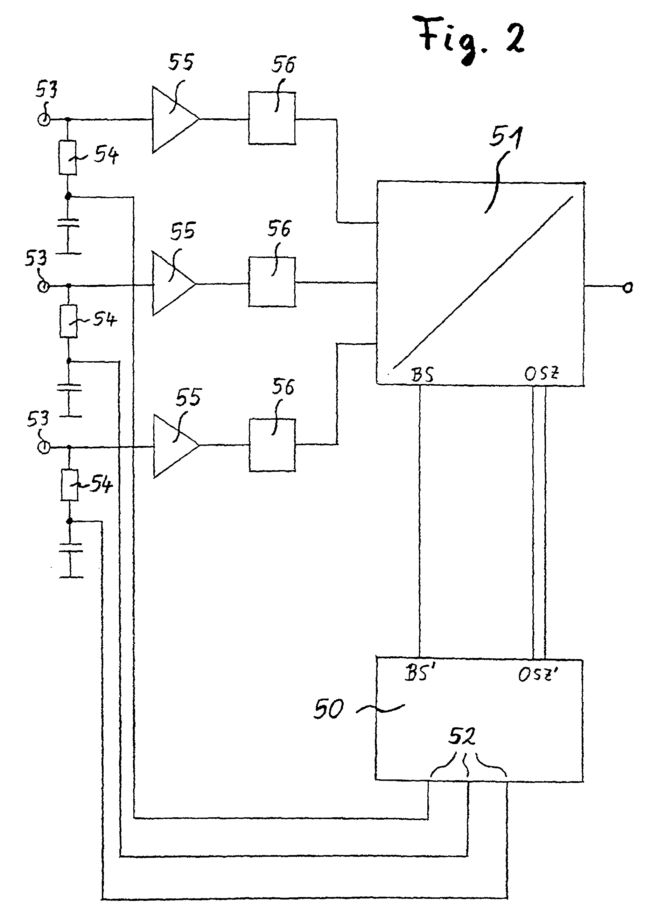

In Fig. 2 ist ein Drei-Band-Tuner mit einer konventionellen Bandumschalteinrichtung dargestellt. Die Bandumschalteinrichtung ist durch eine integrierte Schaltung 50 realisiert, die eine PLL-Schaltung und einen Bandschalter umfaßt. Der Phasenregelkreis weist eine Ladungspumpe, einen Phasendetektor und einen Frequenzteiler auf. Die integrierte Schaltung 50 weist einen Bandschaltausgang BS auf, um einer Misch/Oszillatorstufe 51 ein Bandschaltsignal zuzuführen, das dem gewünschten Frequenzband entspricht. Weiterhin ist die integrierte Schaltung 50 mit der Misch/Oszillatorstufe 51 über einen Oszillatoranschluß OSZ gekoppelt. Weiterhin weist die integrierte Schaltung 50 drei Digitalausgänge 52 auf, die zum Schalten jeweils eines HF-Eingangs 53 vorgesehen sind. Die HF-Eingänge 53 werden über Widerstände 54 und die Digitalausgängen 52 an die Masse gelegt und auf diese Weise abgeschaltet. Zwischen den HF-Eingängen 53 und der Misch/Oszillatorstufe 51 sind jeweils ein HF-Vorverstärker 55 und eine Filterschaltung 56 geschaltet. Die durch die integrierte Schaltung 50 realisierte Bandumschalteinrichtung regelt einerseits die Misch/Oszillatorstufe 51 auf die gewünschte Frequenz und schaltet andererseits den entsprechenden HF-Eingang 53.

Diese konventionelle integrierte Schaltung, die sowohl eine PLL-Schaltung als auch einen Bandschalter umfaßt, haben den Nachteil, daß zwischen dem Phasenrauschen und dem Trägersignal ein unzureichender Abstand erreicht wird, der nicht für alle gewünschten Anwendungen, insbesondere für die digitale Signalübertragung, ausreicht. Dies ist beispielsweise auf einen zu niedrigen Strom der Ladungspumpe und ein zu hohes Teilerverhältnis des Frequenzteilers zurückzuführen.

Es ist Aufgabe der Erfindung, eine Bandumschalteinrichtung der eingangs genannten Art bereitzustellen, mit der ein verbesserter Abstand zwischen dem Phasenrauschen und dem Trägersignal erreicht wird. Insbesondere ist im Abstand von 1 kHz zum Trägersignal ein Phasenrauschpegel von -70 dB erwünscht.

Diese Aufgabe wird durch den Gegenstand des Patentanspruches 1 gelöst. Weiterhin wird diese Aufgabe durch die Gegenstände der Patentansprüche 16 und 18 gelöst.

Erfindungsgemäß ist vorgesehen, daß die Ladungspumpe einen Strom von wahlweise zwischen einem Minimalwert und einem Maximalwert erzeugt, der Frequenzteiler ein Teilerverhältnis von weniger als 512 aufweist, die Bandumschalteinrichtung wenigstens n+1 Digitalausgänge und einen aus mindestens n-1 Widerstandselementen bestehenden Spannungsteiler umfaßt, wobei ein erstes Widerstandselement zwischen einer Versorgungsspannung und einem n+1-ten Digitalausgang, ein zweites Widerstandselement zwischen dem n+1-ten Digitalausgang und einem ersten von n-2 weiteren Digitalausgängen und die übrigen n-3 Widerstandselemente in Reihe, jeweils zwischen zwei der n-2 weiteren Digitalausgänge geschaltet sind und der n+1-te Digitalausgang den Bandschaltausgang zum Schalten der Misch/Oszillatorstufe bildet.

Insbesondere ist die Bandumschalteinrichtung für einen Drei-Band-Tuner vorgesehen. In diesem Fall weist die Bandumschalteinrichtung wenigstens vier Digitalausgänge auf. Der Spannungsteiler umfaßt in diesem Fall wenigstens zwei Widerstandselemente. Das erste Widerstandselement ist zwischen der Versorgungsspannung und dem vierten Digitalausgang geschaltet. Das zweite Widerstandselement ist zwischen dem vierten Digitalausgang und dem einzigen weiteren Digitalausgang geschaltet.

Vorzugsweise erzeugt die Ladungspumpe wahlweise einen Strom, dessen Minimalwert 120 µA und dessen Maximalwert 1200 µA beträgt. Insbesondere ist beim Frequenzteiler wahlweise ein Teilerverhältnis von 2 bis 320 vorgesehen. Damit läßt sich der Rauschabstand gegenüber dem vorgenannten Stand der Technik verbessern.

Der Bandschalter ist somit durch den Spannungsteiler realisiert, der mit einer Versorgungsspannung und zwei Digitalausgängen gekoppelt ist. Der Koppelpunkt zwischen den beiden Widerständen bildet somit den Bandschaltausgang. Je nach Zustand an den beiden Digitalausgängen liegt am Bandschaltausgang der Spannungspegel der Versorgungsspannung, der Massepegel oder ein dazwischenliegender Wert an, der durch die Widerstandswerte der beiden Widerstände vorbestimmt ist. Vorzugsweise kann vorgesehen sein, daß der erste und zweite Widerstand den gleichen Widerstandswert innehaben. In diesem Fall liegt am Bandschaltausgang entweder der Spannungspegel der Versorgungsspannung, der Masse oder der halben Versorgungsspannung an. Damit sind die Abstände zwischen zwei benachbarten Spannungspegeln etwa gleich, wodurch die größtmögliche Genauigkeit bei der Identifizierung der Zustände des Bandschaltsignals durch die Misch/Oszillatorstufe gewährleistet ist.

Vorzugsweise kann vorgesehen sein, daß die Bandumschalteinrichtung eine integrierte Schaltung aufweist, welche die Ladungspumpe, den Frequenzteiler, den Phasendetektor, den Steuereingang, den Oszillatoranschluß und die Digitalausgänge umfaßt. Dazu kann insbesondere eine integrierte PLL-Schaltung verwendet werden. Auf diese Weise läßt sich die Bandumschalteinrichtung kostengünstig realisieren.

Weiterhin kann vorgesehen sein, daß die Bandumschalteinrichtung für den Drei-Band-Tuner vier Digitalausgänge aufweist, der weitere Digitalausgang einerseits und der erste, zweite oder dritte Digitalausgang andererseits durch einen gemeinsamen Digitalausgang realisiert sind und zwischen dem gemeinsamen Digitalausgang und dem zugeordneten HF-Eingang ein Entkoppelelement geschaltet ist. Integrierte PLL-Schaltungen, die für die Bandumschalteinrichtung geeignet sind, weisen oftmals lediglich vier Digitalausgänge auf. In diesem Fall verwenden erfindungsgemäß der Spannungsteiler und einer der drei HF-Eingänge einen gemeinsamen Digitalausgang. Dabei ist ein Entkoppelelement zwischen dem gemeinsamen Digitalausgang und dem jeweiligen HF-Eingang vorgesehen. Vorzugsweise ist als Entkoppelelement eine Diode vorgesehen, die vom gemeinsamen Digitalausgang zu dem entsprechenden HF-Eingang in Durchlaßrichtung geschaltet ist. Auf diese Weise läßt sich die erfindungsgemäße Bandumschalteinrichtung kostengünstig realisieren. Für einen n-Band-Tuner sind bei diesem Schaltungsprinzip n+1 Digitalausgänge vorgesehen.

Alternativ kann vorgesehen sein, daß die Bandumschalteinrichtung wenigstens 2n-1 Digitalausgänge aufweist.

Für einen Drei-Band-Tuner weist die Bandumschalteinrichtung dann wenigstens fünf Digitalauszüge auf. In diesem Fall sind 3 Digitalausgänge jeweils einem HF-Eingang zugeordnet, und zwei weitere Digitalausgänge für den Spannungsteiler vorgesehen. In diesem Fall ist kein Entkoppelelement erforderlich. Diese Ausführungsform kann mit integrierten Phasenregelkreisen realisiert werden, die 5 oder mehr Digitalausgänge aufweisen. Auf diese Weise läßt sich durch eine besonders einfach Beschaltung eine Bandumschalteinrichtung realisieren.

Vorteilhafterweise kann vorgesehen sein, daß die Versorgungsspannung derjenigen der integrierten Schaltung entspricht. Dies ermöglicht einen besonders einfachen Aufbau des Spannungsteilers.

Weiterhin kann vorgesehen sein, daß die Bandumschalteinrichtung einen standardisierten Steuereingang für externe Signale aufweist. Insbesondere ist ein Steuereingang vorgesehen, der an einen seriellen Datenbus anschließbar ist. Vorzugsweise ist der serielle Datenbus ein standardisierter I²C-Bus. Auf diese Weise ist die Kompatibilität mit zahlreichen Schaltungen, insbesondere Eingabeschaltungen gewährleistet.

Für eine konkrete Ausführungsform kann vorgesehen sein, daß die Bandumschalteinrichtung die integrierte Schaltung vom Typ TSA5059 aufweist. Diese integrierte Schaltung ist eine PLL-Schaltung mit vier Digitalausgängen und einem Eingang, der an den I²C-Bus anschließbar ist.

Alternativ dazu kann vorgesehen sein, daß die Bandumschalteinrichtung die integrierte Schaltung vom Typ SP5669 aufweist. Auch diese integrierte Schaltung ist eine PLL-Schaltung mit vier Digitalausgängen und einem zum I²C-Bus kompatiblen Steuereingang.

Die Erfindung wird nachstehend hinsichtlich weiterer Merkmale und Vorteile anhand der Beschreibung eines Ausführungsbeispiels und unter Bezugnahme auf die beigefügten Zeichnungen näher erläutert. Hierbei zeigen:
- Fig. 1: ein schematisches Blockschaltbild eines Drei-Band-Tuners mit einer erfindungsgemäßen Bandumschalteinrichtung; und
- Fig. 2: ein schematische Blockdarstellung eines Drei-Band-Tuners mit einer Bandumschalteinrichtung gemäß dem Stand der Technik.

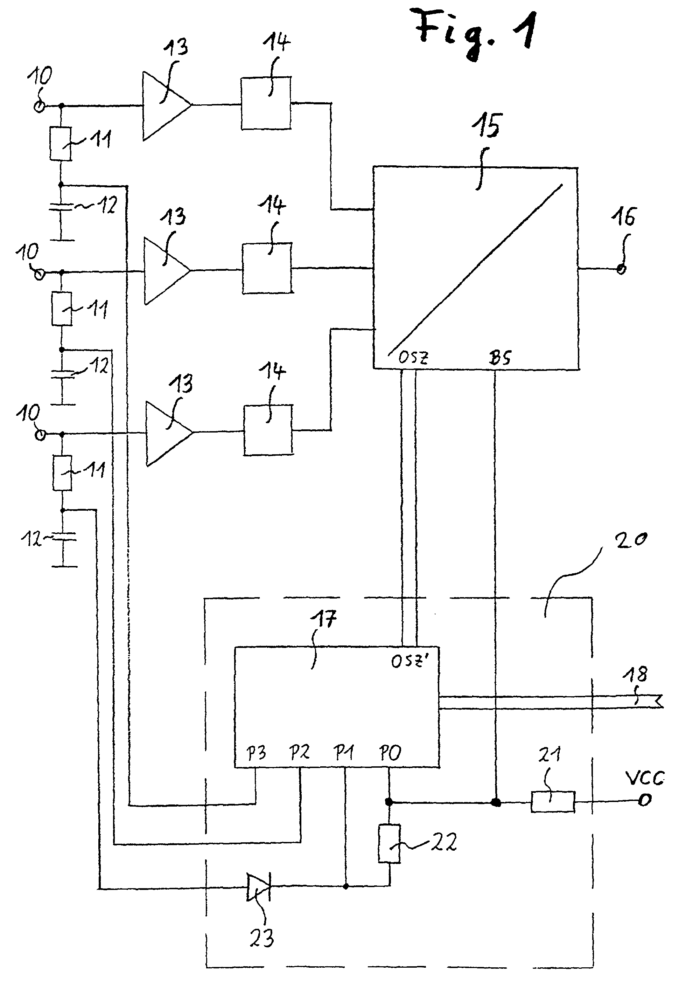

Fig. 1 zeigt ein Blockschaltbild eines Drei-Band-Tuners mit einer erfindungsgemäßen Bandumschalteinrichtung 20. Der Drei-Band-Tuner weist drei HF-Eingänge 10 auf. Die HF-Eingänge 10 sind jeweils über einen Widerstand 11 und einen nachgeschalteten Kondensator 12 mit Masse verbunden. Jedem der drei HF-Eingänge 10 ist ein Vorverstärker 13 nachgeschaltet. Die Vorverstärker 13 sind vorzugsweise als MOSFET-IC ausgebildet. Jeden der Vorverstärker 13 ist eine Filterschaltung 14 nachgeschaltet. Jedem HF-Eingang 10 mit nachgeschaltetem Vorverstärker 13 und Filterschaltung 14 ist jeweils ein vorbestimmtes Frequenzband zugeordnet. Jede der drei Filterschaltungen 14 ist jeweils mit einem Eingang einer Misch/Oszillatorstufe 15 gekoppelt. Die Misch/Oszillatorstufe 15 weist einen ZF-Ausgang 16 auf. Weiterhin weist die Misch/Oszillatorstufe 15 einen Bandschalt-Eingang BS und einen Oszillatoranschluß OSZ auf. Der Oszillatoranschluß OSZ der Misch/Oszillatorstufe 15 ist mit einem Oszillatoranschluß OSZ' der Bandumschalteinrichtung 20 gekoppelt. Die Bandumschalteinrichtung 20 umfaßt eine integrierte PLL-Schaltung 17, den Oszillatoranschluß OSZ', einen I²C-Bus-Anschluß 18 sowie vier Digitalausgänge P0 bis P3. Weiterhin weist die Bandumschalteinrichtung 20 einen aus zwei seriellen Widerständen 21, 22 bestehenden Spannungsteiler auf. Der erste Widerstand 21 ist zwischen der Versorgungsspannung VCC der integrierten Schaltung 17 und dem Digitalausgang P0 geschaltet. Der zweite Widerstand 22 ist zwischen dem Digitalausgang P0 und dem Digitalausgang P1 geschaltet. Der Digitalausgang P0, der den Koppelpunkt der beiden Widerstände 21 und 22 bildet, ist mit dem Bandschalteingang BS der Misch/Oszillatorstufe 15 verbunden. Der Digitalausgang P1 ist außerdem über eine Diode 23 mit dem Koppelpunkt des Widerstands 11 und des Kondensators 12 von einem der HF-Eingänge 10 verbunden. Die Digitalausgänge P2 und P3 sind jeweils mit den beiden verbleibenden Koppelpunkten zwischen den Widerständen 11 und den Kondensatoren 12 verbunden. Über den I²C-Bus 18 ist die Bandumschalteinrichtung extern ansteuerbar.

Die Funktionsweise des Drei-Band-Tuners ist nachfolgend beschrieben. Die Bandumschalteinrichtung 20 hat eine Doppelfunktion. In Abhängigkeit von einem externen Steuersignal, das an dem I²C-Bus 18 anliegt, werden einerseits die vorbestimmte Frequenz eingestellt und andererseits das entsprechende Frequenzband geschaltet. Das Schalten der Frequenzbänder erfolgt zum einen durch Ansteuern der Misch/Oszillatorstufe 15 und zum anderen durch Schalten der HF-Eingänge 10. Die HF-Eingänge 10 werden dadurch abgeschaltet, indem die Digitalausgänge P1, P2 bzw. P3 niederohmig werden und damit den jeweiligen HF-Eingang 10 über den Widerstand 11 an die Masse legen. Ist dagegen der Digitalausgang P1, P2 bzw. P3 hochohmig, werden die von außen zugeführten HF-Signale dem jeweiligen Vorverstärker 13 zugeführt. Auf diese Weise sind von der Bandumschalteinrichtung 20 stets wenigstens zwei der drei HF-Eingänge 10 abgeschaltet. Weiterhin führt die Bandumschalteinrichtung 20 der Misch/Oszillatorstufe 15 ein Bandschaltsignal zu, um diejenigen Baugruppen der Misch/Oszillatorstufe 15 einzuschalten, die dem jeweiligen Frequenzband zugeordnet sind. Das Bandschaltsignal wird von der Bandumschalteinrichtung 20 am Digitalausgang P0 erzeugt und der Misch/Oszillatorstufe 15 über den Bandschalteingang BS zugeführt. Das Bandschaltsignal kann drei verschiedene Spannungspegel innehaben, die den drei Frequenzbändern zugeordnet sind. Die Spannungspegel hängen von den Zuständen der Digitalausgänge P0 und P1 ab. Sind beide Eingänge P0 und P1 hochohmig, liegt das Bandschaltsignal BS auf dem Pegel der Versorgungsspannung VCC. Ist der Digitalausgang P0 niederohmig, liegt das Bandschaltsignal BS auf dem Pegel der Masse. Ist der Digitalausgang PO hochohmig und der Digitalausgang P1 niederohmig, liegt das Bandschaltsignal BS etwa auf dem Pegel der halben Versorgungsspannung VCC. Weiterhin hat die Bandumschalteinrichtung 20 die Funktion, die dem gewünschten Kanal zugeordnete Frequenz in der Misch/Oszillatorstufe 15 einzustellen. Diese erfolgt auf herkömmliche Weise mittels eines Phasendetektors, einer Ladungspumpe und eines spannungsgesteuerten Oszillators. Der Phasendetektor und die Ladungspumpe sind Bestandteile der integrierten Schaltung 17. Der spannungsgesteuerte Oszillator ist Bestandteil der Misch/Oszillatorstufe 15. Die erfindungsgemäße Bandumschalteinrichtung 20 und die Misch/Oszillatorstufe 15 sind über deren Oszillatoranschlüsse OSZ' und OSZ miteinander auf konventionelle Weise verbunden.

Die erfindungsgemäße Bandumschalteinrichtung 20 hat den Vorteil, daß eine integrierte PLL-Schaltung, die eigentlich nicht für einen Drei-Band-Tuner vorgesehen ist, durch eine einfache Beschaltung dafür verwendet werden kann. Die erfindungsgemäße Bandumschalteinrichtung 20 kann nach dem gleichen Prinzip auch für Tuner mit mehr als drei Frequenzbändern verwendet werden.

### Bezugszeichenliste

- 10: HF-Eingänge
- 11: Widerstände
- 12: Kondensatoren
- 13: Vorverstärker
- 14: Filterschaltungen
- 15: Misch/Oszillatorstufe
- 16: ZF-Ausgang
- 17: integrierte PLL-Schaltung
- 18: Steuereingang/ I²C-Bus
- 20: Bandumschalteinrichtung
- 21: erster Widerstand
- 22: zweiter Widerstand
- 23: Diode
- 50: integrierte PLL-Schaltung
- 51: Misch/Oszillatorstufe
- 52: Digitalausgänge
- 53: HF-Eingänge
- 54: Widerstande
- 55: Vorverstärker

## Patentansprüche

1. Bandumschalteinrichtung für einen n-Band-Tuner mit einem Bandschaltausgang (BS') und einer integrierten PLL-Schaltung (17), die eine Ladungspumpe, einen Frequenzteiler, einen Phasendetektor, einen I²C-Steuereingang (18), einen Oszillatcrausgang (OSZ') und wenigstens n-Digitalausgänge aufweist, wobei der Bandschaltausgang und der Oszillatorausgang (OSZ') zur Kopplung an eine Misch/Oszillatorstufe (15) vorgesehen sind, um eine vorbestimmte Frequenz einzustellen, und n-Digitalausgänge (P0 bis P3) zum Schalten von jeweils einem HF-Eingang (10) des n-Band-Tuners vorgesehen sind,
**dadurch gekennzeichnet,**
**daß** die Ladungspumpe einen Strom von wahlweise zwischen 120 µA und 1200 µA erzeugt, der Frequenzteiler ein Teilerverhältnis von weniger als 512 aufweist, die PLL-Schaltung (17) wenigstens n+1 Digitalausgänge aufweist, die Bandumschalteinrichtung (20) einen aus mindestens n-1 Widerstandselementen (21, 22) bestehenden Spannungsteiler umfaßt, wobei ein erstes Widerstandselement (21) zwischen einer Versorgungsspannung (VCC) und einem n+1-ten Digitalausgang (P0), ein zweites Widerstandselement (22) zwischen dem n+1-ten Digitalausgang (P0) und einem ersten von n-2 weiteren Digitalausgängen (P1) und die übrigen n-3 Widerstandselemente in Reihe, jeweils zwischen zwei der n-2 weiteren Digitalausgänge geschaltet sind und der n+1-te Digitalausgang (P0) den Bandschaltausgang (BS') zum Schalten der Misch/Oszillatorstufe (15) bildet.

2. Bandumschalteinrichtung nach Anspruch 1,
**dadurch gekennzeichnet,**
**daß** die Bandumschalteinrichtung (20) für einen Drei-Band-Tuner (n=3) vorgesehen ist.

3. Bandumschalteinrichtung nach Anspruch 2,
**dadurch gekennzeichnet,**
**daß** die Bandumschalteinrichtung (20) vier Digitalausgänge (P0, P1, P2, P3) aufweist, wobei der weitere Digitalausgang und der dritte Digitalausgang einen gemeinsamen Digitalausgang (P1) bilden, und ein Entkoppelelement zwischen dem gemeinsamen Digitalausgang (P1) und dem zugeordneten HF-Eingang (10) geschaltet ist.

4. Bandumschalteinrichtung nach Anspruch 1,
**dadurch gekennzeichnet,**
**daß** die Bandumschalteinrichtung (20) n+1 Digitalausgänge aufweist, wobei die n-2 weiteren Digitalausgänge mit jeweils einem vom zweiten bis zum n-ten Digitalausgang einen gemeinsamen Digitalausgang bilden.

5. Bandumschalteinrichtung nach Anspruch 3 oder 4,
**dadurch gekennzeichnet,**
**daß** das Entkoppelelement eine Diode (23) ist.

6. Bandumschalteinrichtung nach Anspruch 1,
**dadurch gekennzeichnet,**
**daß** die Bandumschalteinrichtung (20) wenigstens 2n-1 Digitalausgänge aufweist, von denen drei den HF-Eingängen (10) und zwei weitere dem Spannungsteiler zugeordnet sind.

7. Bandumschalteinrichtung nach einem der Ansprüche 1-6,
**dadurch gekennzeichnet,**
**daß** die Versorgungsspannung (VCC) die Versorgungsspannung der integrierten Schaltung (17) ist.

8. Bandumschalteinrichtung nach einem der Ansprüche 1-7,
**dadurch gekennzeichnet,**
**daß** der Steuereingang (18) an einen Steuerbus anschließbar ist.

9. Bandumschalteinrichtung nach Anspruch 8,
**dadurch gekennzeichnet,**
**daß** der Steuerbus ein serieller Datenbus ist.

10. Bandumschalteinrichtung nach Anspruch 9,
**dadurch gekennzeichnet,**
**daß** der Steuerbus ein standardisierter I²C-Bus ist.

11. Bandumschalteinrichtung nach einem der Ansprüche 1-10,
**dadurch gekennzeichnet,**
**daß** für den Strom der Ladungspumpe der Minimalwert 120 µA und der Maximalwert 1200 µA beträgt.

12. Bandumschalteinrichtung nach einem der Ansprüche 1-11,
**dadurch gekennzeichnet,**
**daß** das Teilerverhältnis des Frequenzteilers wahlweise zwischen 2 und 320 beträgt.

13. n-Band-Tuner mit einer Bandumschalteinrichtung (20), einer Misch/Oszillatorstufe (15) und drei HF-Eingängen (10), wobei die HF-Eingänge (10) mit der Misch/Oszillatorstufe (15) gekoppelt sind,
**dadurch gekennzeichnet,**
**daß** die Bandumschalteinrichtung (20) gemäß einem der Ansprüche 1-12 ausgebildet ist.

14. Drei-Band-Tuner nach Anspruch 13,
**dadurch gekennzeichnet,**
**daß** den drei HF-Eingängen (10) jeweils ein Vorverstärker (13) nachgeschaltet ist.

15. Verwendung der integrierten PLL-Schaltung, gemäß Anspruch 1, wobei die PLL-Schaltung wenigstens vier Digitalausgänge (P0, P1, P2, P3) aufweist als Bandumschalteinrichtung (20) in einem Drei-Band-Tuner, welche gemäß einem der Ansprüche 1-12 ausgebildet ist.

## Claims

1. Band-switching device for an n-band tuner having a band-switching output (BS') and an integrated PLL circuit (17), which band-switching device has a charge pump, a frequency divider, a phase detector, an I²C control input (18), an oscillator output (OSZ') and at least n digital outputs, wherein the band-switching output and the oscillator output (OSZ') are provided for coupling to a mixer/oscillator stage (15) in order to set a predetermined frequency, and n digital outputs (P0 to P3) are provided to switch a respective HF input (10) of the n-band tuner, **characterized in that** the charge pump generates a current of optionally between 120 µA and 1200 µA, the frequency divider has a division ratio of less than 512, the PLL circuit (17) has at least n + 1 digital outputs, the band-switching device (20) comprises a voltage divider comprising at least n - 1 resistance elements (21, 22), wherein a first resistance element (21) is connected between a supply voltage (VCC) and an (n + 1)th digital output (P0), a second resistance element (22) is connected between the (n + 1)th digital output (P0) and a first of n - 2 further digital outputs (P1) and the remaining n - 3 resistance elements are connected in series, in each case between two of the n - 2 further digital outputs and the (n + 1)th digital output (P0) forms the band-switching output (BS') for switching the mixer/oscillator stage (15).

2. Band-switching device according to Claim 1, **characterized in that** the band-switching device (20) is provided for a three-band tuner (n = 3).

3. Band-switching device according to Claim 2, **characterized in that** the band-switching device (20) has four digital outputs (P0, P1, P2, P3), wherein the further digital output and the third digital output form a common digital output (P1), and a decoupling element is connected between the common digital output (P1) and the assigned HF input (10).

4. Band-switching device according to Claim 1, **characterized in that** the band-switching device (20) has n + 1 digital outputs, wherein the n - 2 further digital outputs form a common digital output with one of the second to the n^{th} digital output in each case.

5. Band-switching device according to Claim 3 or 4, **characterized in that** the decoupling element is a diode (23).

6. Band-switching device according to Claim 1, **characterized in that** the band-switching device (20) has at least 2n - 1 digital outputs, of which three are assigned to the HF inputs (10) and two further digital outputs are assigned to the voltage divider.

7. Band-switching device according to one of Claims 1-6, **characterized in that** the supply voltage (VCC) is the supply voltage of the integrated circuit (17).

8. Band-switching device according to one of Claims 1 - 7, **characterized in that** the control input (18) is connectable to a control bus.

9. Band-switching device according to Claim 8, **characterized in that** the control bus is a serial data bus.

10. Band-switching device according to Claim 9, **characterized in that** the control bus is a standardized I²C bus.

11. Band-switching device according to one of Claims 1 - 10, **characterized in that**, for the current of the charge pump, the minimum value is 120 µA and the maximum value is 1200 µA.

12. Band-switching device according to one of Claims 1 - 11, **characterized in that** the division ratio of the frequency divider is optionally between 2 and 320.

13. n-Band tuner having a band-switching device (20), a mixer/oscillator stage (15) and three HF inputs (10), wherein the HF inputs (10) are coupled to the mixer/oscillator stage (15), **characterized in that** the band-switching device (20) is constructed in accordance with one of Claims 1 - 12.

14. Three-band tuner according to Claim 13, **characterized in that** a preamplifier (13) is connected in each case downstream of the three HF inputs (10).

15. Use of the integrated PLL circuit in accordance with Claim 1, wherein the PLL circuit has at least four digital outputs (P0, P1, P2, P3), as band-switching device (20) in a three-band tuner that is constructed in accordance with one of Claims 1 - 12.

## Revendications

1. Dispositif de commutation de bande pour un syntoniseur à n bandes avec une sortie de commutation de bande (BS') et un circuit PLL intégré (17), qui présente une pompe de charge, un diviseur de fréquence, un comparateur de phases, une entrée de commande I²C (18), une sortie oscillateur (OSZ') et au moins n sorties numériques, la sortie de commutation de bande et la sortie oscillateur (OSZ') étant prévues pour le couplage à un étage mélangeur/oscillateur (15), pour régler une fréquence prédéfinie, et n sorties numériques (PO à P3) étant prévues pour commuter chacune une entrée HF (10) du syntoniseur à n bandes,
**caractérisé en ce**
**que** la pompe de charge produit un courant entre 120 µA et 1200 µA au choix, le diviseur de fréquence présente un rapport de moins de 512, le circuit PLL (17) présente au moins n+1 sorties numériques, le dispositif de commutation de bande (20) comprend un diviseur de tension composé d'au moins n-1 éléments de résistance (21, 22), un premier élément de résistance (21) étant monté entre une tension d'alimentation (VCC) et une n+1^{ème} sortie numérique (PO), un deuxième élément de résistance (22) étant monté entre la n+1^{ème} sortie numérique (PO) et une première de n-2 autres sorties numériques (P1), et les autres n-3 éléments de résistance étant montés en série, chacun entre deux des n-2 autres sorties numériques, et la n+1^{ème} sortie numérique (PO) formant la sortie de commutation de bande (BS') pour commuter l'étage mélangeur/oscillateur (15).

2. Dispositif de commutation de bande suivant la revendication 1,
**caractérisé en ce**
**que** le dispositif de commutation de bande (20) est prévu pour un syntoniseur à trois bandes (n=3).

3. Dispositif de commutation de bande suivant la revendication 2,
**caractérisé en ce**
**que** le dispositif de commutation de bande (20) présente quatre sorties numériques (PO, P1, P2, P3), l'autre sortie numérique et la troisième sortie numérique formant une sortie numérique commune (P1), et un élément de découplage étant monté entre la sortie numérique commune (P1) et l'entrée HF associée (10).

4. Dispositif de commutation de bande suivant la revendication 1,
**caractérisé en ce**
**que** le dispositif de commutation de bande (20) présente n+1 sorties numériques, les n-2 autres sorties numériques formant une sortie numérique commune chacune avec l'une de la deuxième à la n^{ième} sortie numérique.

5. Dispositif de commutation de bande selon l'une des revendications 3 et 4,
**caractérisé en ce**
**que** l'élément de découplage est une diode (23).

6. Dispositif de commutation de bande suivant la revendication 1,
**caractérisé en ce**
**que** le dispositif de commutation de bande (20) présente au moins 2n-1 sorties numériques, dont trois sont associées aux entrées HF (10) et deux autres au diviseur de tension.

7. Dispositif de commutation de bande suivant l'une des revendications 1 à 6,
**caractérisé en ce**
**que** la tension d'alimentation (VCC) est la tension d'alimentation du circuit intégré (17).

8. Dispositif de commutation de bande suivant l'une des revendications 1 à 7,
**caractérisé en ce**
**que** l'entrée de commande (18) peut être reliée à un bus de commande.

9. Dispositif de commutation de bande suivant la revendication 8,
**caractérisé en ce**
**que** le bus de commande est un bus de données sériel.

10. Dispositif de commutation de bande suivant la revendication 9,
**caractérisé en ce**
**que** le bus de commande est un bus I²C normalisé.

11. Dispositif de commutation de bande suivant l'une des revendications 1 à 10,
**caractérisé en ce**
**que** la valeur minimale est de 120 µA et la valeur maximale de 1200 µA pour le courant de la pompe de charge.

12. Dispositif de commutation de bande suivant l'une des revendications 1 à 11,
**caractérisé en ce**
**que** le rapport du diviseur de fréquence est compris entre 2 et 320 au choix.

13. Syntoniseur à n bandes comprenant un dispositif de commutation de bande (20), un étage mélangeur/oscillateur (15) et trois entrées HF (10), les entrées HF (10) étant couplées à l'étage mélangeur/oscillateur,
**caractérisé en ce**
**que** le dispositif de commutation de bande (20) est réalisé suivant l'une des revendications 1 à 12.

14. Syntoniseur à trois bandes suivant la revendication 13,
**caractérisé en ce**
**qu'**un préamplificateur (13) est monté en aval de chacune des trois entrées HF (10).

15. Utilisation du circuit PLL intégré suivant la revendication 1, dans lequel le circuit PLL présente au moins quatre sorties numériques (PO, P1, P2, P3) comme dispositif de commutation de bande (20), qui est réalisé suivant l'une des revendications 1 à 12, dans un syntoniseur à trois bandes.
